# EUROPEAN PATENT SPECIFICATION

(11) **EP 4 538 342 B1**
(45) Date of publication and mention of the grant of the patent: **11.03.2026**
(21) Application number: 24153450.2
(22) Date of filing: 23.01.2024
(51) Int. Cl.: C09J 7/10, H10F 19/80

(54) **ADHESIVE FILM APPLIED TO PHOTOVOLTAIC MODULE AND PHOTOVOLTAIC MODULE**
AUF FOTOVOLTAISCHES MODUL AUFGETRAGENE KLEBEFOLIE UND FOTOVOLTAISCHES MODUL
FILM ADHÉSIF APPLIQUÉ À UN MODULE PHOTOVOLTAÏQUE ET MODULE PHOTOVOLTAÏQUE

(30) Priority: 12.10.2023 CN 202311319791
(43) Date of publication of application: 16.04.2025
(73) Proprietor: JINKO SOLAR CO., LTD, ShangRao, Jiangxi 334100 (CN); Jinko Solar (Shangrao) Co., Ltd, Shangrao, Jiangxi (CN)
(72) Inventor: TAO, Wusong, JIANGXI, 334100 (CN); PENG, Yingying, JIANGXI, 334100 (CN); XIE, Yunfei, JIANGXI, 334100 (CN); GUO, Liang, JIANGXI, 334100 (CN)
(74) Representative: DREISS Patentanwälte PartG mbB

(56) References cited:
- CN-A- 111 732 901
- CN-A- 115 725 244
- CN-A- 116 836 634
- CN-U- 217 556 101
- CN-U- 218 241 864

## Description

### TECHNICAL FIELD

The present disclosure relates to the technical field of photovoltaics, and in particular, to an adhesive film for a photovoltaic module and a photovoltaic module.

### BACKGROUND

As a device that utilizes solar energy to generate electricity, a photovoltaic module has a wide range of application markets.

The photovoltaic module includes a laminate. The laminate includes a light-transmitting sheet, an adhesive film, a solar cell string, and a back sheet that are laminated.

In the prior art, due to lamination and thermal warping of the adhesive film after lamination, part of materials in the adhesive film may overflow and flow relative to the laminate, which may easily cause an actual local thickness of the adhesive film to be less than a preset thickness. That is, part of the adhesive film is thinner. The thinner part in the adhesive film is prone to aging, and adhesion between the thinner part and the solar cell string is easily reduced. That is, the thinner part is easily separated from the solar cell string, and the solar cell string is easily damaged by a foreign matter outside the photovoltaic module. Alternatively, the thinner part has poor puncture resistance, and the thinner part is easily punctured by a solder strip of the solar cell string, causing a problem of electrical short circuit. Therefore, in the prior art, the photovoltaic module has poor operational reliability. Provided prior documents CN116836634A, CN218241864U, CN217556101U, CN111732901A and CN115725244A are considered as relevant.

### SUMMARY

In view of this, the present disclosure provides an adhesive film for a photovoltaic module and a photovoltaic module to help solve the problem of poor operational reliability of the photovoltaic module in the prior art. The invention is set out in the appended set of claims.

In a first aspect, the present disclosure provides an adhesive film for a photovoltaic module, wherein the adhesive film includes an edge portion, a transition portion, and a middle portion. The edge portion is provided with a first embossment recessed towards the interior of the edge portion. The transition portion is provided with a second embossment recessed towards the interior of the transition portion. The middle portion is provided with a third embossment recessed towards the interior of the middle portion. The edge portion is connected to the middle portion through the transition portion, a recessed space volume per unit area of the third embossment is greater than a recessed space volume per unit area of the second embossment, and the recessed space volume per unit area of the second embossment is greater than a recessed space volume per unit area of the first embossment.

Since the recessed space volume per unit area (unit: mm³/m²) of the first embossment is smaller than recessed space volume per unit area (unit: mm³/m²) of the second embossment, the edge portion is filled with more materials per unit area than the transition portion. In detail, the gram weight per unit area M₁ (unit: g/m²) of the edge portion is greater than the gram weight per unit area M₂ (unit: g/m²) of the transition portion. Similarly, since the recessed space volume per unit area (unit: mm³/m²) of the second embossment is smaller than the recessed space volume per unit area (unit: mm³/m²) of the third embossment, the transition portion is filled with more materials per unit area than the middle portion. In detail, the gram weight per unit area M₂ (unit: g/m²) of the transition portion is greater than the gram weight per unit area M₃ (unit: g/m²) of the middle portion. Therefore, a relation of the gram weight M₁>the gram weight M₂>the gram weight M₃ is formed. Through the above parameter setting, during lamination and thermal warping, part of materials in the adhesive film that may overflow from an edge of the laminate are pre-compensated and arranged at the edge portion, and after lamination and thermal warping of the adhesive film, a final actual thickness of the edge portion is still within a preset thickness range of the edge portion. Similarly, through the above parameter setting, during lamination and thermal warping, part of the materials in the adhesive film required to flow relative to each other inside the laminate (e.g., the transition portion flows to the edge portion or the transition portion flows to the middle portion) are pre-compensated and arranged at the transition portion, and after lamination and thermal warping of the adhesive film, a final actual thickness of the transition portion is still within a preset thickness range of the transition portion. Therefore, a final actual thickness of the adhesive film in the present disclosure after lamination and thermal warping is still within the preset thickness range. Compared with the adhesive film in the prior art, the adhesive film in the present disclosure has a thickness that meets a requirement for an actual operating environment, the adhesive film is not prone to aging, adhesion between the adhesive film and the solar cell string is relatively large, the adhesive film and the solar cell string are not easily separated, and the solar cell string is reliably protected by the adhesive film. On the other hand, the adhesive film has good puncture resistance, and the adhesive film is difficult to be punctured by the solder strip of the solar cell string. That is, it is difficult to cause a problem of electrical short circuit. Therefore, the photovoltaic module with the adhesive film of the present disclosure also has higher operational reliability and higher user experience.

The third embossment has a set minimum depth D₃, the second embossment has a set average depth D₂, and the first embossment has a set maximum depth D₁, where D₃>D₂>D₁.

In some embodiments, the second embossment has a set minimum depth D₂^{min} and a set maximum depth D₂^{max}, where D₂^{min}=D₁ and D₂^{max}=D₃, and the depth of the second embossment gradually decreases along a direction from the middle portion to the edge portion.

In some embodiments, the adhesive film is made of ethylene-vinyl acetate (EVA), and there is a set difference i between the depth D₃ and the depth D₁, where 0.1 mm≤i≤0.2 mm; or the adhesive film is made of polyolefin elastomer (POE), and there is a set difference j between the depth D₃ and the depth D₁, where 0.11 mm≤j≤0.22 mm.

In some embodiments, 0.03 mm≤D₁≤0.1 mm or 0.15 mm≤D₃≤0.3 mm.

The edge portion has a set width W₁, where 40 mm≤W₁≤60 mm, and the transition portion has a set width W₂, where 40 mm≤W₂≤60 mm.

In some embodiments, the edge portion has a set gram weight per unit area M₁, the transition portion has a set gram weight per unit area M₂, the middle portion has a set gram weight per unit area M₃, where M₁>M₂>M₃, and there is a set difference k between the gram weight M₁ and the gram weight M₃, where 100 g/m²≤k≤200 g/m².

In some embodiments, a thickness of the edge portion, a thickness of the transition portion, and a thickness of the middle portion are the same.

In some embodiments, the adhesive film is in a shape of a rectangle, and the edge portion is provided on at least one pair of opposite sides of the adhesive film.

In a second aspect, the present disclosure provides a photovoltaic module. The photovoltaic module includes the adhesive film for a photovoltaic module described in the above content. The photovoltaic module of the present disclosure has the technical effect described in the above content. Details are not described herein again.

### BRIEF DESCRIPTION OF DRAWINGS

In order to more clearly illustrate the technical solutions in some embodiments of the present disclosure, the accompanying drawings used in the description of the embodiments will be briefly introduced below. It is apparent that the accompanying drawings in the following description are only some embodiments of the present disclosure, and other accompanying drawings can be obtained by those of ordinary skill in the art from the provided accompanying drawings without creative efforts.
FIG. 1 is a schematic structural diagram of a laminate according to some embodiments of the present disclosure;
FIG. 2 is a top view of an adhesive film according to some embodiments of the present disclosure;
FIG. 3 is a side view of the adhesive film according to some embodiments of the present disclosure;
FIG. 4 is a side view of the adhesive film according to some embodiments of the present disclosure;
FIG. 5 is a top view of the adhesive film according to some embodiments of the present disclosure;
FIG. 6 is a top view of the adhesive film according to some embodiments of the present disclosure; and
FIG. 7 is a top view of the adhesive film according to some embodiments of the present disclosure.
   100: laminate;
   10: adhesive film;
      1: edge portion;
         11: first embossment;
      2: transition portion;
         21: second embossment;
      3: middle portion;
         31: third embossment;
   20: solar cell string;
   30: light-transmitting sheet;
   40: back sheet.

### DESCRIPTION OF EMBODIMENTS

In order to better understand the technical solutions of the present disclosure, some embodiments of the present disclosure are described in detail below with reference to the accompanying drawings.

It should be clear that the described embodiments are only some rather than all of the embodiments of the present disclosure.

The terms used in the embodiments of the present disclosure are merely for the purpose of describing specific embodiments and are not intended to limit the present disclosure. As used in the embodiments of the present disclosure and the appended claims, the singular forms of "a/an", "said", and "the" are also intended to include plural forms, unless otherwise clearly specified in the context.

It should be understood that the term "and/or" used herein describes an association relationship between associated objects and indicates that three relationships may exist. For example, A and/or B may indicate the following three cases: only A exists, both A and B exist, and only B exists. In addition, the character "/" herein generally indicates an "or" relationship between the associated objects.

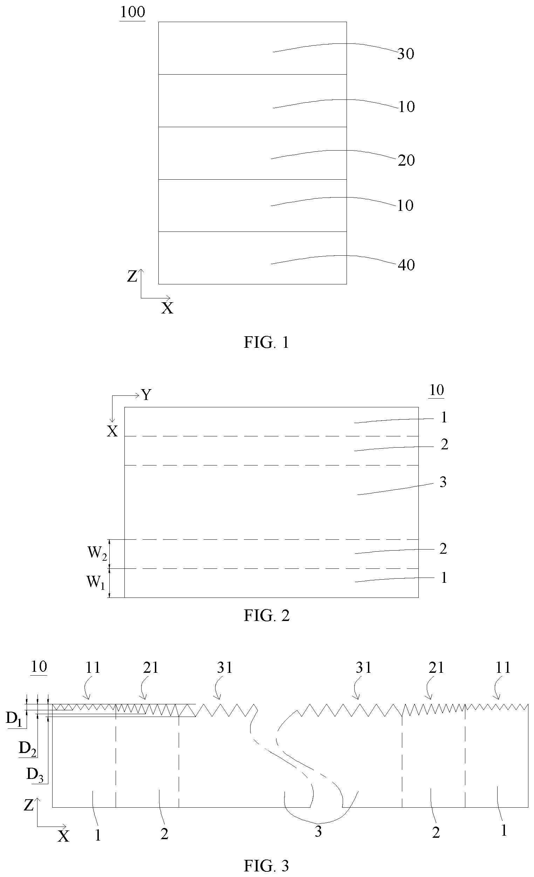

In a first aspect, some embodiments of the present disclosure provide a photovoltaic module. Referring to FIG. 1, the photovoltaic module includes a laminate 100. The laminate 100 includes an adhesive film 10, a solar cell string 20, a light-transmitting sheet 30, and a back sheet 40. Two opposite sides of the solar cell string 20 respectively abut against corresponding adhesive films 10. A side of one adhesive film 10 facing away from the solar cell string 20 abuts against the light-transmitting sheet 30, and a side of the other adhesive film 10 facing away from the solar cell string 20 abuts against the back sheet 40. The back sheet 40 may be made of an opaque material, and sunlight shines only to front surfaces of solar cells of the solar cell string 20 through the light-transmitting sheet 30 and the adhesive film 10. The back sheet 40 may alternatively be made of a light-transmitting material, and sunlight reflected by the ground may shine on back surfaces of the solar cells of the solar cell string 20 through the back sheet 40 and the adhesive film 10. The adhesive film 10 may encapsulate the solar cell string 20. In addition, the adhesive film 10 may have good elasticity, and the adhesive film 10 may have a cushioning effect on the solar cell string 20 and reduce a possibility of cracking of the cells in the solar cell string 20 due to an external force.

Referring to FIG. 1, before the laminate 100 is formed prior to lamination, the adhesive film 10, the solar cell string 20, the light-transmitting sheet 30, and the back sheet 40 are first stacked to form a stacking member, and a surface of the adhesive film 10 may be provided with an embossment (an embossing roller is used to roll the surface of the adhesive film 10 to form the embossment) to increase a friction coefficient of the surface of the adhesive film 10 and reduce a possibility of slippage between the adhesive film 10 and adjacent components.

With respect to the problem in the Background, the subsequent content herein focuses on a structure of the adhesive film 10 prior to lamination.

Referring to FIG. 2, in a second aspect, some embodiments of the present disclosure provide an adhesive film 10 for a photovoltaic module. The adhesive film 10 includes an edge portion 1, a transition portion 2, and a middle portion 3. Referring to FIG. 3, the edge portion 1 is provided with a first embossment 11 recessed towards the interior of the edge portion 1. The transition portion 2 is provided with a second embossment 21 recessed towards the interior of the transition portion 2. The middle portion 3 is provided with a third embossment 31 recessed towards the interior of the middle portion 3. The edge portion 1 is connected to the middle portion 3 through the transition portion 2, a recessed space volume per unit area of the third embossment 31 is greater than a recessed space volume per unit area of the second embossment 21, and the recessed space volume per unit area of the second embossment 21 is greater than a recessed space volume per unit area of the first embossment 11. The recessed space volume per unit area (unit: mm³/m²) is interpreted as follows: a portion with a set area is cut out from the adhesive film 10, and a recessed space volume of an embossment of the portion is the recessed space volume per unit area.

In this embodiment, referring to FIG. 3, since the recessed space volume per unit area (unit: mm³/m²) of the first embossment 11 is smaller than recessed space volume per unit area (unit: mm³/m²) of the second embossment 21, the edge portion 1 is filled with more materials per unit area than the transition portion 2. In detail, the gram weight per unit area M₁ (unit: g/m²) of the edge portion 1 is greater than the gram weight per unit area M₂ (unit: g/m²) of the transition portion 2. Similarly, since the recessed space volume per unit area (unit: mm³/m²) of the second embossment 21 is smaller than recessed space volume per unit area (unit: mm³/m²) of the third embossment 31, the transition portion 2 is filled with more materials per unit area than the middle portion 3. In detail, the gram weight per unit area M₂ (unit: g/m²) of the transition portion 2 is greater than the gram weight per unit area M₃ (unit: g/m²) of the middle portion 3. Therefore, a relation of the gram weight M₁>the gram weight M₂>the gram weight M₃ is formed. Through the above parameter setting, during lamination and thermal warping, part of materials in the adhesive film 10 that may overflow from an edge of the laminate 100 are pre-compensated and arranged at the edge portion 1, and after lamination and thermal warping of the adhesive film 10, a final actual thickness of the edge portion 1 is still within a preset thickness range of the edge portion 1. Similarly, through the above parameter setting, during lamination and thermal warping, part of the materials in the adhesive film 10 required to flow relative to each other inside the laminate 100 (e.g., the transition portion 2 flows to the edge portion 1 or the transition portion 2 flows to the middle portion 3) are pre-compensated and arranged at the transition portion 2, and after lamination and thermal warping of the adhesive film 10, a final actual thickness of the transition portion 2 is still within a preset thickness range of the transition portion 2. Therefore, a final actual thickness of the adhesive film 10 in some embodiments of the present disclosure after lamination and thermal warping is still within the preset thickness range. Compared with the adhesive film in the prior art, the adhesive film 10 in some embodiments of the present disclosure has a thickness that meets a requirement for an actual operating environment, the adhesive film 10 is not prone to aging, adhesion between the adhesive film 10 and the solar cell string 20 is relatively large, the adhesive film 10 and the solar cell string 20 are not easily separated, and the solar cell string 20 is reliably protected by the adhesive film 10. On the other hand, the adhesive film 10 has good puncture resistance, and the adhesive film 10 is difficult to be punctured by the solder strip of the solar cell string 20. That is, it is difficult to cause a problem of electrical short circuit. Therefore, the photovoltaic module with the adhesive film 10 in some embodiments of the present disclosure also has higher operational reliability and higher user experience.

During lamination and thermal warping, an amount of the materials in the edge portion 1 that overflow from the edge of the laminate 100 is greater than an amount of part of the materials in the transition portion 2 that relatively flow inside the laminate 100, and part of the materials in the transition portion 2 may flow towards the middle portion 3. Therefore, the relation of the gram weight M₁>the gram weight M₂>the gram weight M₃ is required to be satisfied.

Specific factors affecting the recessed space volume may be a recessed space depth, a recessed space width, and a recessed space length, and changing any of the factors of the recessed space depth, the recessed space width, and the recessed space length may make the recessed space volume different. The following content herein focuses on different recessed space depths of the embossments of different portions.

Referring to FIG. 3, the third embossment 31 has a set minimum depth D₃, the second embossment 21 has a set average depth D₂, and the first embossment 11 has a set maximum depth D₁, where D₃>D₂>D₁. When other geometric conditions are the same, through the arrangement, an arrangement in which the recessed space volume per unit area of the first embossment 11 is smaller than the recessed space volume per unit area of the second embossment 21 and an arrangement in which the recessed space volume per unit area of the second embossment 21 is smaller than the recessed space volume per unit area of the third embossment 31 may be formed, that is, the relation of the gram weight M₁>the gram weight M₂>the gram weight M₃ is formed, so as to achieve the related technical effect described in the above content.

Depth values of the third embossment 31 at different positions may be the same or different. In some embodiments of the present disclosure, only the depth values of the third embossment 31 are required to be no less than the minimum depth D₃. Depth values of the second embossment 21 at different positions may be the same or different. In some embodiments of the present disclosure, only the average depth D₂ of the second embossment 21 is required to be between D₃ and D₁. Depth values of the first embossment 11 at different positions may be the same or different. In some embodiments of the present disclosure, only the depth values of the first embossment 11 are required to be no less than the maximum depth D₁. The subsequent content herein is mainly described based on an example in which the depth values of the third embossment 31 at different positions are the same, the depth values of the second embossment 21 at different positions are the same, and the depth values of the first embossment 11 at different positions are the same.

In some embodiments, referring to FIG. 3, the second embossment 21 has a set minimum depth D₂^{min} and a set maximum depth D₂^{max}, where D₂^{min}=D₁ and D₂^{max}=D₃, and the depth of the second embossment 21 gradually decreases along a direction from the middle portion 3 to the edge portion 1. Through the arrangement, depths of junctions between the first embossment 11 and the second embossment 21 are the same. That is, there are no sudden depth changes at the junctions between the first embossment 11 and the second embossment 21. In other words, it is not easy to form structural ribs at joints between the edge portion 1 and the transition portion 2. Similarly, through the arrangement, depths of junctions between the second embossment 21 and the third embossment 31 are also the same. That is, there are no sudden depth changes at the junctions between the second embossment 21 and the third embossment 31. In other words, it is not easy to form structural ribs at joints between the transition portion 2 and the middle portion 3, either. Since the depth of the second embossment 21 gradually decreases along a direction from the middle portion 3 to the edge portion 1, that is, there are no sudden depth changes between the second embossment 21 at different positions, it is less likely to form structural ribs in the transition portion 2. Through the above structural arrangement, the adhesive film 10 is not prone to wrinkles. That is, the adhesive film 10 is easily recycled into a roll material by a winding mechanism.

An average value of the minimum depth D₂^{min} and the maximum depth D₂^{max} is D₂.

Density is a property of a material. Therefore, gram weight per unit area of respective portions of the adhesive film 10 can be made different only by setting the depths of the embossments of the portions of the adhesive film 10 to be different. If a same gram weight difference is satisfied, depth differences required for the embossments of the portions of the adhesive film 10 made of different materials (different density) are also different.

In some embodiments, referring to FIG. 3, the adhesive film 10 is made of EVA, and there is a set difference i between the depth D₃ and the depth D₁, where 0.1 mm≤i≤0.2 mm. The difference i may be, for example, 0.1 mm, 0.11 mm, 0.12 mm, 0.13 mm, 0.14 mm, 0.15 mm, 0.16 mm, 0.17 mm, 0.18 mm, 0.19 mm, or 0.2 mm.

In this embodiment, referring to FIG. 3, if the adhesive film 10 is made of EVA and the depth D₃ of the third embossment 31 meets a condition of use, when the difference i is less than 0.1 mm, the depth D₁ of the first embossment 11 is excessively large, the gram weight per unit area of the edge portion 1 is smaller, and after lamination and thermal warping, an actual thickness of the edge portion 1 is likely to be less than a minimum value in a preset thickness range, that is, the edge portion 1 is thinner, so the photovoltaic module 10 with the adhesive film 10 has poor operational reliability. If the adhesive film 10 is made of EVA and the depth D₃ of the third embossment 31 meets a condition of use, when the difference i is greater than 0.2 mm, the depth D₁ of the first embossment 11 is excessively small, the gram weight per unit area of the edge portion 1 is greater, and after lamination and thermal warping, more materials in the adhesive film 10 overflow from the edge of the laminate 100, and more waste is formed, that is, a small quantity of adhesive films 10 are manufactured from a unit quantity of adhesive film raw materials, so manufacturing efficiency is low. Therefore, it is better that the difference i is within a range of 0.1 mm≤i≤0.2 mm.

In this embodiment, referring to FIG. 3, if the adhesive film 10 is made of EVA and the depth D₁ of the first embossment 11 meets a condition of use, when the difference i is less than 0.1 mm, the depth D₃ of the third embossment 31 is excessively large, the gram weight per unit area of the middle portion 3 is greater, and after lamination and thermal warping, an actual thickness of the middle portion 3 is likely to be greater than a maximum value in the preset thickness range, that is, the middle portion 3 is thicker, and the thicker middle portion 3 easily exerts a squeezing force on the solar cell string 20, so the solar cells of the solar cell string 20 are prone to cracking. If the adhesive film 10 is made of EVA and the depth D₁ of the first embossment 11 meets a condition of use, when the difference i is greater than 0.2 mm, the depth D₃ of the third embossment 31 is excessively small, the gram weight per unit area of the middle portion 3 is smaller, and after lamination and thermal warping, the actual thickness of the middle portion 3 is likely to be less than the minimum value in the preset thickness range, that is, the middle portion 3 is thinner, and the thinner middle portion 3 is easily delaminated from adjacent components, so the photovoltaic module 10 with the adhesive film 10 has poor operational reliability. Therefore, it is better that the difference i is within a range of 0.1 mm≤i≤0.2 mm.

In some embodiments, referring to FIG. 3, the adhesive film 10 is made of POE, and there is a set difference j between the depth D₃ and the depth D₁, where 0.11 mm≤j≤0.22 mm. The difference j may be, for example, 0.11 mm, 0.12 mm, 0.13 mm, 0.14 mm, 0.15 mm, 0.16 mm, 0.17 mm, 0.18 mm, 0.19 mm, 0.2 mm, 0.21 mm, or 0.22 mm.

In this embodiment, referring to FIG. 3, if the adhesive film 10 is made of POE and the depth D₃ of the third embossment 31 meets a condition of use, when the difference j is less than 0.11 mm, the depth D₁ of the first embossment 11 is excessively large, the gram weight per unit area of the edge portion 1 is smaller, and after lamination and thermal warping, an actual thickness of the edge portion 1 is likely to be less than the minimum value in the preset thickness range, that is, the edge portion 1 is thinner, so the photovoltaic module 10 with the adhesive film 10 has poor operational reliability. If the adhesive film 10 is made of POE and the depth D₃ of the third embossment 31 meets a condition of use, when the difference j is greater than 0.22mm, the depth D₁ of the first embossment 11 is excessively small, the gram weight per unit area of the edge portion 1 is greater, and after lamination and thermal warping, more materials in the adhesive film 10 overflow from the edge of the laminate 100, and more waste is formed, that is, a small quantity of adhesive films 10 are manufactured from a unit quantity of adhesive film raw materials, so manufacturing efficiency is low. Therefore, it is better that the difference j is within a range of 0.11 mm≤j≤0.22 mm.

In this embodiment, referring to FIG. 3, if the adhesive film 10 is made of POE and the depth D₁ of the first embossment 11 meets a condition of use, when the difference j is less than 0.11mm, the depth D₃ of the third embossment 31 is excessively large, the gram weight per unit area of the middle portion 3 is greater, and after lamination and thermal warping, the actual thickness of the middle portion 3 is likely to be greater than the maximum value in the preset thickness range, that is, the middle portion 3 is thicker, and the thicker middle portion 3 easily exerts a squeezing force on the solar cell string 20, so the solar cells of the solar cell string 20 are prone to cracking. If the adhesive film 10 is made of POE and the depth D₁ of the first embossment 11 meets a condition of use, when the difference j is greater than 0.22mm, the depth D₃ of the third embossment 31 is excessively small, the gram weight per unit area of the middle portion 3 is smaller, and after lamination and thermal warping, the actual thickness of the middle portion 3 is likely to be less than the minimum value in the preset thickness range, that is, the middle portion 3 is thinner, and the thinner middle portion 3 is easily delaminated from adjacent components, so the photovoltaic module 10 with the adhesive film 10 has poor operational reliability. Therefore, it is better that the difference j is within a range of 0.11 mm≤j≤0.22 mm.

In other embodiments, the adhesive film 10 may alternatively be made of polyvinyl butyral (PVB).

In other embodiments, two different adhesive films 10 in a same photovoltaic module may be made of a same material or different materials.

In other embodiments, the adhesive film 10 may be formed by splicing different materials. For example, two sides of a POE adhesive film are spliced with an EVA adhesive film.

In other embodiments, the adhesive film 10 may be co-extruded from different materials, such as an EVA-POE-EVA co-extruded adhesive film, or an EVA-POE co-extruded adhesive film.

The subsequent content herein focuses on the adhesive film 10 formed of a single material.

In some embodiments, 0.03 mm≤D₁≤1 mm. D₁ may be, for example, 0.03 mm, 0.07 mm, 0.1 mm, 0.2 mm, 0.3 mm, 0.4 mm, 0.5 mm, 0.6 mm, 0.7 mm, 0.8 mm, 0.9 mm, or 1 mm. Through the setting, the depth of the first embossment 11 of the edge portion 1 may be shallower.

In some embodiments, 0.15 mm≤D₃≤0.3 mm. D₃ may be, for example, 0.15 mm, 0.16 mm, 0.17 mm, 0.18 mm, 0.19 mm, 0.2 mm, 0.21 mm, 0.22 mm, 0.23 mm, 0.24 mm, 0.25 mm, 0.26 mm, 0.27 mm, 0.28 mm, 0.29 mm, or 0.3 mm. Through the setting, the depth of the third embossment 31 of the middle portion 3 may be deeper.

In some embodiments, according to the above numerical ranges for D₁ and D₃, D₂=(D₁+D₃)/2, and D₂^{min}=D₁ and D₂^{max}=D₃. Through the setting, the depth of the second embossment 21 in the transition portion 2 gradually changes.

The edge portion 1 has a set width W₁, where 40 mm≤W₁≤60 mm. The width W₁ may be, for example, 40 mm, 41 mm, 42 mm, 43 mm, 44 mm, 45 mm, 46 mm, 47 mm, 48 mm, 49 mm, 50 mm, 51 mm, 52 mm, 53 mm, 54 mm, 55 mm, 56 mm, 57 mm, 58 mm, 59 mm, or 60 mm. A user may selectively set the width W₁ of the edge portion 1 within the range according to an actual use requirement.

In this embodiment, under a same length condition, if the width W₁<40 mm, the edge portion 1 is excessively narrow, the gram weight per unit area of the edge portion 1 is smaller, that is, an amount of the materials in the adhesive film 10 that are pre-compensated and arranged at the edge portion 1 is smaller, and after lamination and thermal warping, the actual thickness of the edge portion 1 is likely to be less than the minimum value in the preset thickness range, that is, the edge portion 1 is thinner, so the photovoltaic module 10 with the adhesive film 10 has poor operational reliability. Under a same length condition, if the width W₁>60 mm, the edge portion 1 is excessively wide, the gram weight per unit area of the edge portion 1 is greater, and after lamination and thermal warping, more materials in the adhesive film 10 overflow from the edge of the laminate 100, and more waste is formed, that is, a small quantity of adhesive films 10 are manufactured from a unit quantity of adhesive film raw materials, so manufacturing efficiency is low. Therefore, it is better that the width W₁ is within the range of 40 mm to 60 mm.

The transition portion 2 has a set width W₂, where 40 mm≤W₂≤60 mm. The width W₂ may be, for example, 40 mm, 41 mm, 42 mm, 43 mm, 44 mm, 45 mm, 46 mm, 47 mm, 48 mm, 49 mm, 50 mm, 51 mm, 52 mm, 53 mm, 54 mm, 55 mm, 56 mm, 57 mm, 58 mm, 59 mm, or 60 mm. The user may selectively set the width W₂ of the transition portion 2 within the range according to an actual use requirement.

In this embodiment, under a same length condition, if the width W₂<40 mm, the transition portion 2 is excessively narrow, the gram weight per unit area of the transition portion 2 is smaller, that is, an amount of the materials in the adhesive film 10 that are pre-compensated and arranged at the transition portion 2 is smaller, and after lamination and thermal warping, the actual thickness of the transition portion 2 is likely to be less than the minimum value in the preset thickness range, that is, the transition portion 2 is thinner, so the photovoltaic module 10 with the adhesive film 10 has poor operational reliability. Under a same length condition, if the width W₂>60 mm, the transition portion 2 is excessively wide, the gram weight per unit area of the transition portion 2 is greater, and a small quantity of adhesive films 10 are manufactured from a unit quantity of adhesive film raw materials, so manufacturing efficiency is low. Therefore, it is better that the width W₂ is within the range of 40 mm to 60 mm.

In some embodiments, the edge portion 1 has a set gram weight per unit area M₁, the transition portion 2 has a set gram weight per unit area M₂, the middle portion 3 has a set gram weight per unit area M₃, where M₁>M₂>M₃, and there is a set difference k between the gram weight M₁ and the gram weight M₃, where 100 g/m²≤k≤200 g/m². The difference k may be, for example, 100 g/m², 105 g/m², 110 g/m², 115 g/m², 120 g/m², 125 g/m², 130 g/m², 135 g/m², 140 g/m², 145 g/m², 150 g/m², 155 g/m², 160 g/m², 165 g/m², 170 g/m², 175 g/m², 180 g/m², 185 g/m², 190 g/m², 195 g/m², or 200 g/m². The user may selectively set the difference k within the range according to an actual use requirement.

In this embodiment, if the gram weight M₃ of the middle portion 3 satisfies a use requirement, when the difference k is less than 100 g/m², the gram weight per unit area of the edge portion 1 is smaller, and after lamination and thermal warping, the actual thickness of the edge portion 1 is likely to be less than the minimum value in a preset thickness range, that is, the edge portion 1 is thinner, so the photovoltaic module 10 with the adhesive film 10 has poor operational reliability. If the gram weight M₃ of the middle portion 3 satisfies a use requirement, when the difference k is greater than 200 g/m², the gram weight per unit area of the edge portion 1 is greater, and after lamination and thermal warping, more materials in the adhesive film 10 overflow from the edge of the laminate 100, and more waste is formed, that is, a small quantity of adhesive films 10 are manufactured from a unit quantity of adhesive film raw materials, so manufacturing efficiency is low. Therefore, it is better that the difference k is within the range of 100 g/m² to 200 g/m².

In this embodiment, if the gram weight M₁ of the edge portion 1 meets a use requirement, when the difference k is less than 100 g/m², the gram weight per unit area of the middle portion 3 is greater, and after lamination and thermal warping, the actual thickness of the middle portion 3 is likely to be greater than the maximum value in the preset thickness range, that is, the middle portion 3 is thicker, and the thicker middle portion 3 easily exerts a squeezing force on the solar cell string 20, so the solar cells of the solar cell string 20 are prone to cracking. If the gram weight M₁ of the edge portion 1 meets a use requirement, when the difference k is greater than 200 g/m², the gram weight per unit area of the middle portion 3 is smaller, and after lamination and thermal warping, the actual thickness of the middle portion 3 is likely to be less than the minimum value in the preset thickness range, that is, the middle portion 3 is thinner, and the thinner middle portion 3 is easily delaminated from adjacent components, so the photovoltaic module 10 with the adhesive film 10 has poor operational reliability. Therefore, it is better that the difference k is within the range of 100 g/m² to 200 g/m².

In some embodiments, a thickness of the edge portion 1, a thickness of the transition portion 2, and a thickness of the middle portion 3 are the same. Through the setting, the adhesive film 10 is relatively flat as a whole, and the adhesive film 10 is not prone to wrinkles, which facilitates the adhesive film 10 to be recycled into the roll material by the winding mechanism.

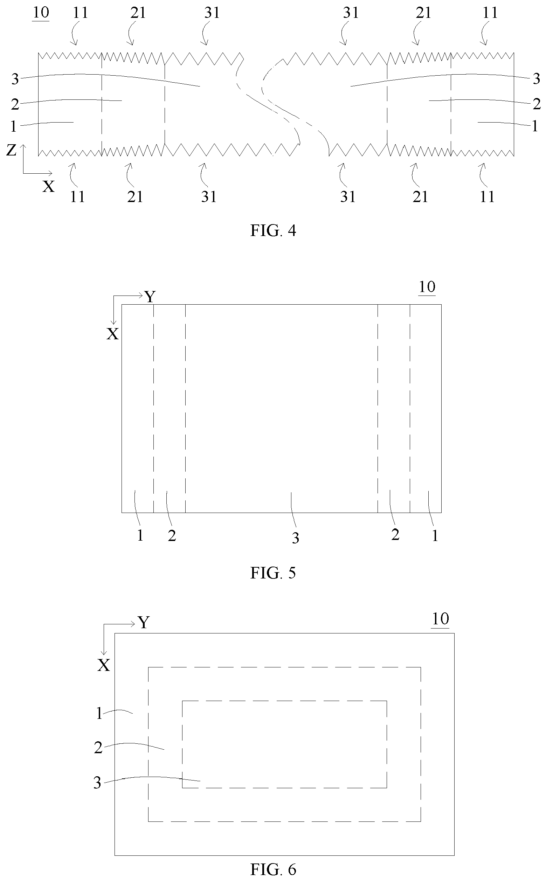

In some embodiments, at least one of two opposite sides of the adhesive film 10 along a thickness direction (a direction parallel to a direction Z) is provided with the first embossment 11, the second embossment 21, and the third embossment 31 described above. Referring to FIG. 3, one side of the adhesive film 10 may be provided with the first embossment 11, the second embossment 21, and the third embossment 31 described above. Referring to FIG. 4, two sides of the adhesive film 10 may be provided with the first embossment 11, the second embossment 21, and the third embossment 31 described above. The above two embossment position setting schemes both have the technical effect mentioned above. Details are not described herein again.

In some embodiments, the adhesive film 10 is in a shape of a rectangle, and the edge portion 1 is provided on at least one pair of opposite sides of the adhesive film 10.

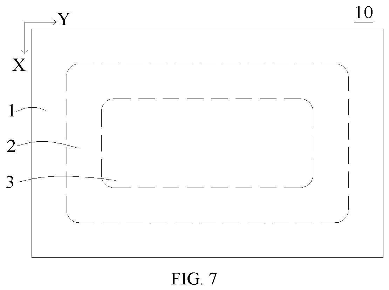

When the solar cell string 20 is arranged along a width direction of the adhesive film 10 (a direction parallel to a direction X), two sides of the adhesive film 10 that are oppositely arranged along the width direction of the adhesive film 10 are prone to thinning due to thermal warping. Therefore, referring to FIG. 2, the two sides of the adhesive film 10 that are oppositely arranged along the width direction of the adhesive film 10 may be provided with the edge portion 1 to reduce a possibility of thinning of the two sides of the adhesive film 10 that are oppositely arranged along the width direction of the adhesive film 10 after thermal warping. When the solar cell string 20 is arranged along a length direction of the adhesive film 10 (a direction parallel to a direction Y), two sides of the adhesive film 10 that are oppositely arranged along the length direction of the adhesive film 10 are prone to thinning due to thermal warping. Therefore, referring to FIG. 5, the two sides of the adhesive film 10 that are oppositely arranged along the length direction of the adhesive film 10 may be provided with the edge portion 1 to reduce a possibility of thinning of the two sides of the adhesive film 10 that are oppositely arranged along the length direction of the adhesive film 10 after thermal warping. Referring to FIG. 6 to FIG. 7, the two sides of the adhesive film 10 that are oppositely arranged along the length direction of the adhesive film 10 (the direction parallel to the direction Y) and the two sides of the adhesive film 10 that are oppositely arranged along the width direction of the adhesive film 10 (the direction parallel to the direction X) may be both provided with the edge portion 1. Through the arrangement, a possibility of thinning of either side of the adhesive film 10 after lamination and thermal warping can be reduced. The edge portion 1, the transition portion 2, and the middle portion 3 all include a structure of a chamfered circle, which can reduce a possibility of stress concentration. A size of the chamfered circle is not limited in some embodiments of the present disclosure. Based on the above content, the user can choose from the above three arrangement manners of the edge portion 1 according to specific parts of the adhesive film 10 that are prone to thinning.

In other embodiments, the adhesive film 10 may be in a shape of a triangle, a circle, an ellipse, or a hexagon.

In some embodiments, recessed spaces of the first embossment 11, the second embossment 21, and the third embossment 31 may be regular recessed spaces or irregular recessed spaces, and the recessed spaces may be in a shape of any one or a combination of a column, a cone, and a ring. Projected along the thickness direction of the adhesive film 10, the first embossment 11, the second embossment 21, and the third embossment 31 may be in a shape of a well, a woven pattern, or a wave pattern.

The direction X, the direction Y, and the direction Z described herein are direction perpendicular in pairs. The dotted lines in the drawings herein are structural dividing lines, and the dotted lines in the drawings herein are structural section lines.

## Claims

1. An adhesive film for a photovoltaic module, comprising:
an edge portion (1) provided with a first embossment (11) recessed towards an interior of the edge portion (1);
a transition portion (2) provided with a second embossment (21) recessed towards an interior of the transition portion (2); and
a middle portion (3) provided with a third embossment (31) recessed towards an interior of the middle portion (3);
wherein the edge portion (1) is connected to the middle portion (3) through the transition portion (2), a recessed space volume per unit area of the third embossment (31) is greater than a recessed space volume per unit area of the second embossment (21), and
the recessed space volume per unit area of the second embossment (21) is greater than a recessed space volume per unit area of the first embossment (11),
wherein the third embossment (31) has a minimum depth D₃, the second embossment (21) has a average depth D₂, and the first embossment (11) has a maximum depth D₁, where D₃>D₂>D₁; and the edge portion (1) has a width W₁, where 40 mm≤W₁≤60 mm, and the transition portion (2) has a width W₂, where 40 mm≤W₂≤60 mm.

2. The adhesive film for a photovoltaic module according to claim 1, wherein
the second embossment (21) has a minimum depth D₂^{min} and a maximum depth D₂^{max}, where D₂^{min}=D₁ and D₂^{max}=D₃, and
a depth of the second embossment (21) gradually decreases along a direction from the middle portion (3) to the edge portion (1).

3. The adhesive film for a photovoltaic module according to claim 1, wherein
the adhesive film (10) is made of ethylene-vinyl acetate (EVA), and a difference i between the depth D₃ and the depth D₁ satisfies 0.1 mm≤i≤0.2 mm; or the adhesive film (10) is made of polyolefin elastomer (POE), and a difference j between the depth D₃ and the depth D₁ satisfies 0.11 mm≤j≤0.22 mm.

4. The adhesive film for a photovoltaic module according to claim 3, wherein
the difference j between the depth D₃ and the depth D₁ satisfies 0.12 mm≤j≤0.21 mm

5. The adhesive film for a photovoltaic module according to claim 1, wherein 0.03 mm≤D₁≤0.1 mm or 0.15 mm≤D₃≤0.3 mm.

6. The adhesive film for a photovoltaic module according to claim 1, wherein
the edge portion (1) has a gram weight per unit area M₁, the transition portion (2) has a gram weight per unit area M₂, the middle portion (3) has a gram weight per unit area M₃, where M₁>M₂>M₃, and
a difference k between the gram weight M₁ and the gram weight M₃ satisfies 100 g/m²≤k≤200 g/m².

7. The adhesive film for a photovoltaic module according to claim 1, wherein
the edge portion (1), the transition portion (2) and the middle portion (3) have a same thickness.

8. The adhesive film for a photovoltaic module according to claim 1, wherein
the adhesive film (10) is in a shape of a rectangle, and the edge portion (1) is provided on at least one pair of opposite sides of the adhesive film (10).

9. A photovoltaic module, comprising a adhesive film (10) for a photovoltaic module, wherein the adhesive film comprises:
an edge portion (1) provided with a first embossment (11) recessed towards an interior of the edge portion (1);
a transition portion (2) provided with a second embossment (21) recessed towards an interior of the transition portion (2); and
a middle portion (3) provided with a third embossment (31) recessed towards an interior of the middle portion (3);
wherein the edge portion (1) is connected to the middle portion (3) through the transition portion (2), a recessed space volume per unit area of the third embossment (31) is greater than a recessed space volume per unit area of the second embossment (21), and
the recessed space volume per unit area of the second embossment (21) is greater than a recessed space volume per unit area of the first embossment (11),
wherein the third embossment (31) has a minimum depth D₃, the second embossment (21) has a average depth D₂, and the first embossment (11) has a maximum depth D₁, where D₃>D₂>D₁; and the edge portion (1) has a width W₁, where 40 mm≤W₁≤60 mm, and the transition portion (2) has a width W₂, where 40 mm≤W₂≤60 mm.

10. The photovoltaic module according to claim 9, wherein
the second embossment (21) has a minimum depth D₂^{min} and a maximum depth D₂^{max}, where D₂^{min}=D₁ and D₂^{max}=D₃, and
a depth of the second embossment (21) gradually decreases along a direction from the middle portion (3) to the edge portion (1).

11. The photovoltaic module according to claim 9, wherein
the adhesive film (10) is made of ethylene-vinyl acetate (EVA), and a difference i between the depth D₃ and the depth D₁ satisfies 0.1 mm≤i≤0.2 mm; or the adhesive film (10) is made of polyolefin elastomer (POE), and a difference j between the depth D₃ and the depth D₁ satisfies 0.11 mm≤j≤0.22 mm.

12. The adhesive film for a photovoltaic module according to claim 11, wherein
the difference j between the depth D₃ and the depth D₁ satisfies 0.12 mm≤j≤0.21 mm.

## Patentansprüche

1. Klebefolie für ein Fotovoltaikmodul, umfassend:
einen Randabschnitt (1), der mit einer ersten Prägung (11) versehen ist, die in Richtung eines Inneren des Randabschnitts (1) vertieft ist;
einen Übergangsabschnitt (2), der mit einer zweiten Prägung (21) versehen ist, die in Richtung eines Inneren des Übergangsabschnitts (2) vertieft ist; und
einen Mittelabschnitt (3), der mit einer dritten Prägung (31) versehen ist, die in Richtung eines Inneren des Mittelabschnitts (3) vertieft ist;
wobei der Randabschnitt (1) mit dem Mittelabschnitt (3) durch den Übergangsabschnitt (2) verbunden ist, ein Volumen eines vertieften Raums pro Einheitsfläche der dritten Prägung (31) größer ist als ein Volumen eines vertieften Raums pro Einheitsfläche der zweiten Prägung (21) und
das Volumen eines vertieften Raums pro Flächeneinheit der zweiten Prägung (21) größer ist als ein Volumen eines vertieften Raums pro Flächeneinheit der ersten Prägung (11),
wobei die dritte Prägung (31) eine minimale Tiefe D₃ aufweist, die zweite Prägung (21) eine durchschnittliche Tiefe D₂ aufweist und die erste Prägung (11) eine maximale Tiefe D₁ aufweist, wobei D₃>D₂>D₁; und der Randabschnitt (1) eine Breite W₁ aufweist, wobei 40 mm≤W₁≤60 mm, und der Übergangsabschnitt (2) eine Breite W₂ aufweist, wobei 40 mm≤W₂≤60 mm.

2. Klebefolie für ein Fotovoltaikmodul nach Anspruch 1, wobei
die zweite Prägung (21) eine minimale Tiefe D₂^{min} und eine maximale Tiefe D₂^{max} aufweist, wobei D₂^{min}=D₁ und D₂^{max}=D₃, und
eine Tiefe der zweiten Prägung (21) entlang einer Richtung von dem Mittelabschnitt (3) zu dem Randabschnitt (1) allmählich abnimmt.

3. Klebefolie für ein Fotovoltaikmodul nach Anspruch 1, wobei
die Klebefolie (10) aus Ethylen-Vinylacetat (EVA) hergestellt ist und eine Differenz i zwischen der Tiefe D₃ und der Tiefe D₁ 0,1 mm≤i≤0,2 mm erfüllt oder die Klebefolie (10) aus Polyolefin-Elastomer (POE) hergestellt ist und eine Differenz j zwischen der Tiefe D₃ und der Tiefe D₁ 0,11 mm≤j≤0,22 mm erfüllt.

4. Klebefolie für ein Fotovoltaikmodul nach Anspruch 3, wobei
die Differenz j zwischen der Tiefe D₃ und der Tiefe D₁ 0,12 mm≤j≤0,21 mm erfüllt.

5. Klebefolie für ein Fotovoltaikmodul nach Anspruch 1, wobei 0,03 mm≤D₁≤0,1 mm oder 0,15 mm≤D₃≤0,3 mm.

6. Klebefolie für ein Fotovoltaikmodul nach Anspruch 1, wobei
der Randabschnitt (1) ein Grammgewicht pro Flächeneinheit M₁ aufweist, der Übergangsabschnitt (2) ein Grammgewicht pro Flächeneinheit M₂ aufweist, der Mittelabschnitt (3) ein Grammgewicht pro Flächeneinheit M₃ aufweist, wobei M₁>M₂>M₃, und
eine Differenz k zwischen dem Grammgewicht pro Flächeneinheit M₁ und dem Grammgewicht pro Flächeneinheit M₃ 100 g/m²≤k≤200 g/m² erfüllt.

7. Klebefolie für ein Fotovoltaikmodul nach Anspruch 1, wobei
der Randabschnitt (1), der Übergangsabschnitt (2) und der Mittelabschnitt (3) eine gleiche Dicke aufweisen.

8. Klebefolie für ein Fotovoltaikmodul nach Anspruch 1, wobei
die Klebefolie (10) eine rechteckige Form aufweist und der Randabschnitt (1) an mindestens einem Paar gegenüberliegender Seiten der Klebefolie (10) bereitgestellt ist.

9. Fotovoltaikmodul, umfassend eine Klebefolie (10) für ein Fotovoltaikmodul, wobei die Klebefolie umfasst:
einen Randabschnitt (1), der mit einer ersten Prägung (11) versehen ist, die in Richtung eines Inneren des Randabschnitts (1) vertieft ist;
einen Übergangsabschnitt (2), der mit einer zweiten Prägung (21) versehen ist, die in Richtung eines Inneren des Übergangsabschnitts (2) vertieft ist; und
einen Mittelabschnitt (3), der mit einer dritten Prägung (31) versehen ist, die in Richtung eines Inneren des Mittelabschnitts (3) vertieft ist;
wobei der Randabschnitt (1) mit dem Mittelabschnitt (3) durch den Übergangsabschnitt (2) verbunden ist, ein Volumen eines vertieften Raums pro Einheitsfläche der dritten Prägung (31) größer ist als ein Volumen eines vertieften Raums pro Einheitsfläche der zweiten Prägung (21) und
das Volumen eines vertieften Raums pro Flächeneinheit der zweiten Prägung (21) größer ist als ein Volumen eines vertieften Raums pro Flächeneinheit der ersten Prägung (11),
wobei die dritte Prägung (31) eine minimale Tiefe D₃ aufweist, die zweite Prägung (21) eine durchschnittliche Tiefe D₂ aufweist und die erste Prägung (11) eine maximale Tiefe D₁ aufweist, wobei D₃>D₂>D₁; und der Randabschnitt (1) eine Breite W₁ aufweist, wobei 40 mm≤W₁≤60 mm, und der Übergangsabschnitt (2) eine Breite W₂ aufweist, wobei 40 mm≤W₂≤60 mm.

10. Fotovoltaikmodul nach Anspruch 9, wobei
die zweite Prägung (21) eine minimale Tiefe D₂^{min} und eine maximale Tiefe D₂^{max} aufweist, wobei D₂^{min}=D₁ und D₂^{max}=D₃, und
eine Tiefe der zweiten Prägung (21) entlang einer Richtung von dem Mittelabschnitt (3) zu dem Randabschnitt (1) allmählich abnimmt.

11. Fotovoltaikmodul nach Anspruch 9, wobei
die Klebefolie (10) aus Ethylen-Vinylacetat (EVA) hergestellt ist und eine Differenz i zwischen der Tiefe D₃ und der Tiefe D₁ 0,1 mm≤i≤0,2 mm erfüllt oder die Klebefolie (10) aus Polyolefin-Elastomer (POE) hergestellt ist und eine Differenz j zwischen der Tiefe D₃ und der Tiefe D₁ 0,11 mm≤j≤0,22 mm erfüllt.

12. Klebefolie für ein Fotovoltaikmodul nach Anspruch 11, wobei
die Differenz j zwischen der Tiefe D₃ und der Tiefe D₁ 0,12 mm≤j≤0,21 mm erfüllt.

## Revendications

1. Film adhésif pour un module photovoltaïque, comprenant :
une partie bord (1) pourvue d'un premier gaufrage (11) en retrait vers un intérieur de la partie bord (1) ;
une partie transition (2) pourvue d'un deuxième gaufrage (21) en retrait vers un intérieur de la partie transition (2) ; et
une partie centrale (3) pourvue d'un troisième gaufrage (31) en retrait vers un intérieur de la partie centrale (3) ;
dans lequel la partie bord (1) est reliée à la partie centrale (3) par la partie transition (2), un volume d'espace en retrait par unité de surface du troisième gaufrage (31) est supérieur à un volume d'espace en retrait par unité de surface du deuxième gaufrage (21), et
le volume d'espace en retrait par unité de surface du deuxième gaufrage (21) est supérieur à un volume d'espace en retrait par unité de surface du premier gaufrage (11),
dans lequel le troisième gaufrage (31) a une profondeur minimale D₃, le deuxième gaufrage (21) a une profondeur moyenne D₂, et le premier gaufrage (11) a une profondeur maximale D₁, où D₃ > D₂ > D₁ ; et la partie bord (1) a une largeur W₁, où 40 mm ≤ W₁ ≤ 60 mm, et la partie transition (2) a une largeur W₂, où 40 mm ≤ W₂ ≤ 60 mm.

2. Film adhésif pour un module photovoltaïque selon la revendication 1, dans lequel
le deuxième gaufrage (21) a une profondeur minimale D₂^{min} et une profondeur maximale D₂^{max}, où D₂^{min} = D₁ et D₂^{max} = D₃, et
une profondeur du deuxième gaufrage (21) diminue progressivement le long d'une direction allant de la partie centrale (3) à la partie bord (1).

3. Film adhésif pour un module photovoltaïque selon la revendication 1, dans lequel
le film adhésif (10) est constitué d'éthylène-acétate de vinyle (EVA), et une différence i entre la profondeur D₃ et la profondeur D₁ satisfait à 0,1 mm ≤ i ≤ 0,2 mm ; ou le film adhésif (10) est constitué d'élastomère de polyoléfine (POE), et une différence j entre la profondeur D₃ et la profondeur D₁ satisfait à 0,11 mm ≤ j ≤ 0,22 mm.

4. Film adhésif pour un module photovoltaïque selon la revendication 3, dans lequel
la différence j entre la profondeur D₃ et la profondeur D₁ satisfait à 0,12 mm ≤ j ≤ 0,21 mm

5. Film adhésif pour un module photovoltaïque selon la revendication 1, dans lequel 0,03 mm ≤ D₁ ≤ 0,1 mm ou 0,15 mm ≤ D₃ ≤ 0,3 mm.

6. Film adhésif pour un module photovoltaïque selon la revendication 1, dans lequel
la partie bord (1) a un poids en grammes par unité de surface M₁, la partie transition (2) a un poids en grammes par unité de surface M₂, la partie centrale (3) a un poids en grammes par unité de surface M₃, où M₁ > M₂ > M₃, et
une différence k entre le poids en gramme M₁ et le poids en gramme M₃ satisfait à 100 g/m² ≤ k ≤ 200 g/m².

7. Film adhésif pour un module photovoltaïque selon la revendication 1, dans lequel
la partie bord (1), la partie transition (2) et la partie centrale (3) ont une même épaisseur.

8. Film adhésif pour un module photovoltaïque selon la revendication 1, dans lequel
le film adhésif (10) a une forme de rectangle, et la partie bord (1) est prévue sur au moins une paire de côtés opposés du film adhésif (10).

9. Module photovoltaïque, comprenant un film adhésif (10) pour un module photovoltaïque, dans lequel le film adhésif comprend :
une partie bord (1) pourvue d'un premier gaufrage (11) en retrait vers un intérieur de la partie bord (1) ;
une partie transition (2) pourvue d'un deuxième gaufrage (21) en retrait vers un intérieur de la partie transition (2) ; et
une partie centrale (3) pourvue d'un troisième gaufrage (31) en retrait vers un intérieur de la partie centrale (3) ;
dans lequel la partie bord (1) est reliée à la partie centrale (3) par la partie transition (2), un volume d'espace en retrait par unité de surface du troisième gaufrage (31) est supérieur à un volume d'espace en retrait par unité de surface du deuxième gaufrage (21), et
le volume d'espace en retrait par unité de surface du deuxième gaufrage (21) est supérieur à un volume d'espace en retrait par unité de surface du premier gaufrage (11),
dans lequel le troisième gaufrage (31) a une profondeur minimale D₃, le deuxième gaufrage (21) a une profondeur moyenne D₂, et le premier gaufrage (11) a une profondeur maximale D₁, où D₃ > D₂ > D₁ ; et la partie bord (1) a une largeur W₁, où 40 mm ≤ W₁ ≤ 60 mm, et la partie transition (2) a une largeur W₂, où 40 mm ≤ W₂ ≤ 60 mm.

10. Module photovoltaïque selon la revendication 9, dans lequel
le deuxième gaufrage (21) a une profondeur minimale D₂^{min} et une profondeur maximale D₂^{max}, où D₂^{min} = D₁ et D₂^{max} = D₃, et
une profondeur du deuxième gaufrage (21) diminue progressivement le long d'une direction allant de la partie centrale (3) à la partie bord (1).

11. Module photovoltaïque selon la revendication 9, dans lequel
le film adhésif (10) est constitué d'éthylène-acétate de vinyle (EVA), et une différence i entre la profondeur D₃ et la profondeur D₁ satisfait à 0,1 mm ≤ i ≤ 0,2 mm ; ou le film adhésif (10) est constitué d'élastomère de polyoléfine (POE), et une différence j entre la profondeur D₃ et la profondeur D₁ satisfait à 0,11 mm ≤ j ≤ 0,22 mm.

12. Film adhésif pour un module photovoltaïque selon la revendication 11, dans lequel
la différence j entre la profondeur D₃ et la profondeur D₁ satisfait à 0,12 mm ≤ j ≤ 0,21 mm.
